Europäisches Patentamt

European Patent Office

Office européen des brevets

(11) Veröffentlichungsnummer: **0 289 730**
**A2**

(12) **EUROPÄISCHE PATENTANMELDUNG**

(21) Anmeldenummer: 88103140.5

(22) Anmeldetag: 02.03.88

(51) Int. Cl.4: **G06F 11/00**

(30) Priorität: 02.05.87 DE 3714630

(43) Veröffentlichungstag der Anmeldung:
09.11.88 Patentblatt 88/45

(84) Benannte Vertragsstaaten:
DE ES FR IT

(71) Anmelder: **Hella KG Hueck & Co.**
**Postfach 28 40**
**D-4780 Lippstadt(DE)**

(72) Erfinder: **Schriek, Josef**
**Beckumer Strasse 155**
**D-4780 Lippstadt(DE)**

(54) Vorrichtung zur Überwachung elektronischer Geräte.

(57) Bei einer Vorrichtung zur Überwachung elektronischer Geräte, insbesondere von Mikrorechnern, mit einem Eingang, der mit einem Ausgang des elektronischen Geräts verbunden ist, mit einer Ladeschaltung, die ein R-C-Glied aufweist, das durch Signale des elektronischen Geräts entladbar ist, mit einem Schwingkreis, der abhängig vom Ladezustand des Kondensators schaltbar ist und der ein periodisches Rücksetzsignal erzeugt, und mit einem Ausgang, der mit einem Eingang des elektronischen Geräts verbunden ist und der das elektronische Gerät mit den Rücksetzsignalen des Schwingkreises versorgt, ist, um eine einfache und kostengünstige Anpassung der Vorrichtung an viele elektronische Schaltungen zu ermöglichen, die Ladeschaltung getrennt von dem Schwingkreis ausgebildet und weist der Schwingkreis ein zweites R-C-Glied zur Taktzeitfestlegung auf.

FIG 1

EP 0 289 730 A2

## Vorrichtung zur Überwachung elektronischer Geräte

Die Erfindung betrifft eine Vorrichtung zur Überwachung elektronischer Geräte, insbesondere von Mikrorechnern, mit einem Eingang, der mit einem Ausgang des elektronischen Geräts verbunden ist, mit einer Ladeschaltung, die ein R-C-Glied aufweist, das durch Signale des elektronischen Geräts entladbar ist, mit einem Schwingkreis, der abhängig vom Ladezustand des Kondensators - schaltbar ist und der ein periodisches Rücksetzsignal erzeugt, und mit einem Ausgang, der mit einem Eingang der elektronischen Schaltung verbunden ist und der das elektronische Gerät mit den Rücksetzsignalen des Schwingkreises versorgt.

Aus der DE-OS 33 32 383 ist eine derartige Vorrichtung bekannt. Dort sind die Ladeschaltung und der Schwingkreis derart zusammengefaßt, daß durch ein R-C-Glied sowohl die Zeitdauer bestimmt wird, in der die elektrische Schaltung Entladepulse liefern soll, als auch die Frequenz zur Erzeugung von Rücksetzsignalen vorgegeben wird.

Die vorbekannte Vorrichtung hat jedoch Nachteile. Dadurch, daß nur ein R-C-Glied vorhanden ist, ist es nicht möglich, die Frequenz zur Erzeugung von Rücksetzsignalen unabhängig von der Zeitdauer zu wählen, in der die elektronische Schaltung einen Entladeimpuls liefern soll. Es ist also häufig nicht möglich, die Rücksetzung an die Erfordernisse der elektronischen Schaltung anzupassen und die Zeitdauer, in der die elektronische Schaltung Entladeimpulse liefern soll, frei zu wählen.

Weiterhin hat die vorbekannte Vorrichtung den Nachteil, daß mit ihr keine Ausgabe eines invertierten Rücksetzsignals möglich ist. Dadurch kann die vorbekannte Vorrichtung nur schwer oder gar nicht an eine vorgegebene elektronische Schaltung angepaßt werden. Das heißt, die vorbekannte Vorrichtung ist möglicherweise nicht allgemein anwendbar.

Schließlich ist es nicht möglich, bei der vorbekannten Vorrichtung einen zusätzlichen Rücksetzausgang vorzusehen, der andere Teile der elektronischen Schaltung oder eine weitere elektronische Schaltung mit insbesondere dauernden Rücksetzsignalen versorgt, weil kein Schaltungspunkt vorhanden ist, der beim Ausbleiben der Entladeimpulse ein konstantes Potential aufweist. Ein derartiger zusätzlicher Rücksetzausgang ist häufig dann wünschenswert, wenn die elektronische Schaltung aus einem elektronischen Mikrorechner und weiteren Schaltungsteilen besteht. Die Anpassung der vorbekannten Vorrichtung an derartige elektronische Schaltungen ist häufig nicht möglich.

Die Erfindung hat die Aufgabe, eine Vorrichtung zu schaffen, die einfach und kostengünstig ist, die allgemein verwendbar ist und die die Anpassung an viele elektronische Schaltungen ermöglicht.

Diese Aufgabe wird dadurch gelöst, daß die Ladeschaltung getrennt von dem Schwingkreis ausgebildet ist und daß der Schwingkreis ein zweites R-C-Glied zur Taktzeitfestlegung aufweist.

Dabei ist durch die erfindungsgemäße Trennung von Ladeschaltung und Schwingkreis gewährleistet, daß am Ausgang der Ladeschaltung ein konstantes Potential herstellbar ist. Das heißt, es ist anders als beim Vorbekannten möglich, einen weiteren Rücksetzausgang vorzusehen, der andere Teile der elektronischen Schaltung oder eine weitere elektronische Schaltung mit Rücksetzsignalen versorgt.

Durch die Trennung von Ladeschaltung und Schwingkreis ist ebenfalls gewährleistet, daß ein zusätzlicher Rücksetzeingang eingerichtet werden kann, der ein invertiertes Rücksetzsignal erzeugt.

Durch das erfindungsgemäß vorgesehene zweite R-C-Glied ist es anders als beim Vorbekannten einfach möglich, die Frequenz zur Erzeugung von Rücksetzsignalen unabhängig von der Zeitdauer zu wählen, in der die elektronische Schaltung einen Entladeimpuls liefern soll.

Die erfindungsgemäße Vorrichtung hat also gegenüber dem Vorbekannten den Vorteil, daß sie allgemein verwendbar ist und daß sie die Anpassung an viele elektronische Schaltungen ermöglicht. Der dazu gegenüber dem Vorbekannten erforderliche Mehraufwand ist vernachlässigbar gegenüber den Vorteilen, die die erfindungsgemäße Vorrichtung aufweist. Der für den Betrieb der erfindungsgemäßen Vorrichtung erforderliche Mehrbedarf an elektrische Energie fällt kaum ins Gewicht, insbesondere dann, wenn als elektronische Bauteile sogenannte C-Mos-Bauteile verwendet werden.

Weitere vorteilhafte Ausgestaltung und Weiterbildung des Erfindungsgegenstands ergeben sich aus den Unteransprüchen.

Ein Ausführungsbeispiel des Erfindungsgegenstands ist in den Zeichnungen dargestellt und wird im folgendem näher erläutert.

Es zeigen:

Figur 1 eine erfindungsgemäße Vorrichtung zur Überwachung der Funktion eines Mikrorechners und

Figur 2 Spannungs-Zeit-Diagramme für verschiedene Meßpunkte der erfindungsgemäßen Vorrichtung nach Figur 1.

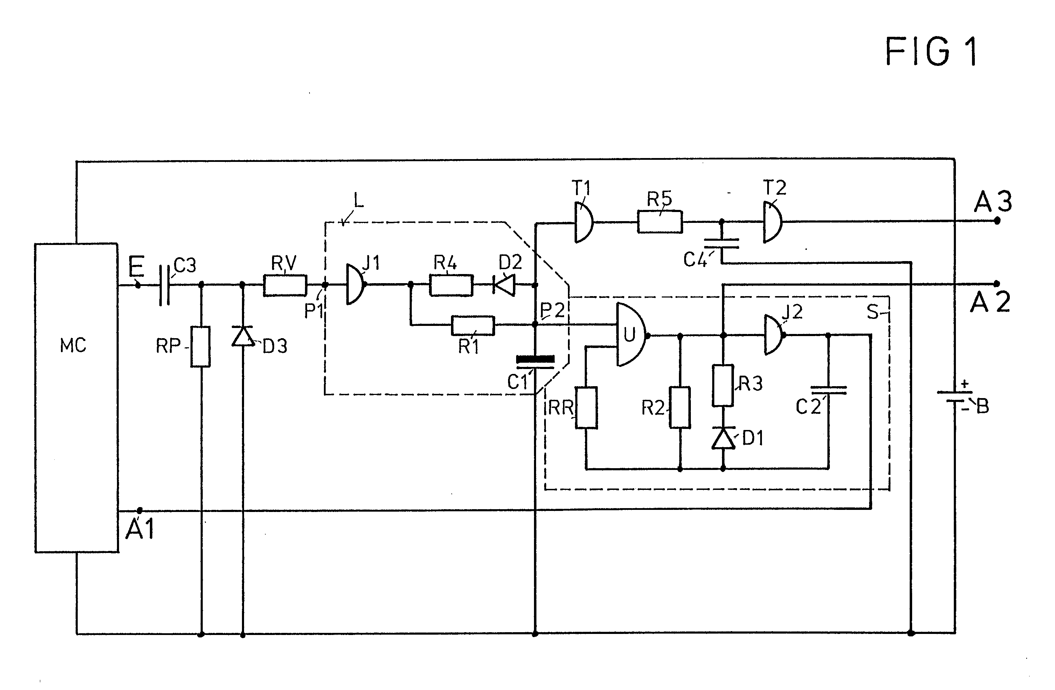

In der Figur 1 wird ein Mikrorechner (MC) aus einer Spannungsquelle (B), die als Batterie eines Kraftfahrzeuges ausgebildet sein kann, mit Strom versorgt. Ein Ausgang des Mikrorechners (MC) ist mit einem Eingang (E) einer erfindungsgemäßen Vorrichtung zur Überwachung des Mikrorechners leitend verbunden. Ein Ausgang (AI) der Vorrichtung zur Überwachung des Mikrorechners ist mit einem Eingang des Mikrorechners verbunden.

Der Mikrorechner (MC) liefert an seinem Ausgang bei einwandfreier Funktion Ausgangssignale, die über den Eingang (E) an einer ersten Elektrode eines dritten Kondensators (C3) anliegen. Die zweite Elektrode des dritten Kondensators (C3) ist über einen sogenannten Pull-Down-Widerstand (RP) mit der Masse bzw. der negativen Versorgungsspannung der Spannungsquelle (B) leitend verbunden. Weiterhin ist die zweite Elektrode des dritten Kondensators (C3) über eine dritte Diode (D3) zum Unwirksammachen von negativen Spannungsspitzen verbunden, deren Anode ebenfalls mit der negativen Versorgungsspannung verbunden ist.

Die zweite Elektrode des dritten Kondensators (C3) ist über einen Vorwiderstand (RV) mit dem Eingang eines als Inverter (I1) ausgebildeten invertierenden Logikelementes verbunden. Der Ausgang des Inverters (I1) ist über eine Parallelschaltung aus einem ersten Widerstand (RI) und einer Serienschaltung eines vierten Widerstandes (R4) und einer zweiten Diode (D2) mit einer ersten Elektrode eines als Elektrolytkondensator ausgebildeten ersten Kondensators (C1) verbunden, dessen zweite Elektrode mit der negativen Versorgungsspannung verbunden ist. Die zweite Diode (D2) ist derart geschaltet, daß ihre Anode mit der ersten Elektrode oder Pluselektrode des Elektrolytkondensators (C1) leitend verbunden ist. Es ist vorteilhaft, als ersten Kondensator (C1) einen Elektrolytkondensator zu verwenden, weil dessen Kapazität bei gegebener Baugröße größer ist als die Kapazität herkömmlicher Folienkondensatoren. Dies kann bei der Bemessung des Zeitraums, in dem. der Mikrorechner einen Entladeimpuls ausgeben soll, von Bedeutung sein.

Der erste Widerstand (RI) gemeinsam mit dem ersten Kondensator (C1) bildet ein erstes R-C-Glied, wobei der erste Widerstand (RI), insbesondere bei der Aufladung des ersten Kondensators (C1), wirksam ist. Der vierte. Widerstand (R4) und der erste Kondensator (C1) bilden ein viertes R-C-Glied, das bedingt durch die Schaltung der zweiten Diode (D2) nur bei der Entladung des ersten Kondensators (C1) wirksam ist. Der erste Widerstand (R1) ist wesentlich größer gewählt als der vierte Widerstand (R4), so daß sich eine langsame Aufladung des ersten Kondensators (C1) und eine - schnelle Entladung des Kondensators (C1) ergibt.

Die erste Elektrode des ersten Kondensators (C1) ist weiterhin parallel mit einem ersten Treiber (T1) und mit einem ersten Eingang eines Nicht-Und-Gliedes (U) leitend verbunden. Der Ausgang des ersten Treibers/Puffers (T1) ist über einen fünften Widerstand (R5) mit dem Eingang eines zweiten Treibers/Puffers (T2) leitend verbunden, dessen Ausgangssignal an einem dritten Ausgang (A3) abgreifbar ist. Zwischen dem fünften Widerstand (R5) und dem Eingang des zweiten Treibers (T2) ist eine erste Elektrode eines vierten Kondensators (C4) angeschlossen, dessen zweite Elektrode leitend mit der negativen Versorgungsspannung der Batterie (B) verbunden ist.

Der fünfte Widerstand (R5) und der vierte Kondensator (C4) bilden ein fünftes R-C-Glied, dessen Zeitkonstante eine Verzögerungszeit bis zum Ändern des Ausgangssignals am dritten Ausgang (A3) vorgibt.

Der Ausgang des invertierenden Nicht-Und-Gliedes (U) ist parallel mit einem zweiten Widerstand (R2), einem dritten Widerstand (R3), einem Eingang eines zweiten, als Invertierer (I2) ausgebildeten Logikelementes und mit einem zweiten Ausgang (A2) leitend verbunden. Der Ausgang des zweiten Invertierers (I2) ist parallel mit einer ersten Elektrode eines zweiten Kondensators (C2) und mit dem ersten Ausgang (A1) leitend verbunden, der an einen Eingang des Mikrorechners (MC) ein Rücksetzsignal liefern soll. Die zweite Elektrode des zweiten Kondensators (C2) ist wiederum parallel mit der Anode einer ersten Diode (D1), deren Kathode mit dem dritten Widerstand (R3) leitend verbunden ist, mit dem zweiten Widerstand (R2) und über einen Rückkopplungswiderstand (RR) mit einem zweiten Eingang des invertierenden Nicht-Und-Gliedes (U) leitend verbunden.

Der zweite Widerstand (R2) und der zweite Kondensator (C2) bilden ein zweites R-C-Glied, und der dritte Widerstand (R3) und der zweite Kondensator (C2) bilden ein drittes R-C-Glied, wobei wiederum durch die erste Diode (D1) und durch die Dimensionierung der Widerstände (R2 und R3) eine unterschiedliche Aufilade-und Entladezeit des zweiten Kondensators (C2) ermöglicht wird.

Der erste Invertierer (I1), der erste Widerstand (R1), der vierte Widerstand (R4), die zweite Diode (D2) und der erste Kondensator (C1) bilden eine Ladeschaltung (L), wobei der Ladezustand des ersten Kondensators (C1) von außen über den Eingang (E) durch den Mikrorechner (MC) beeinflußbar ist.

Das invertierende Nicht-Und-Glied (U), der zweite Invertierer (I2), der zweite Kondensator (C2), die erste Diode (D1), der zweite Widerstand (R2), der dritte Widerstand (R3) und der Rückkopplungswiderstand (RR) bilden einen freilaufenden Schwingkreis (S), der über den ersten Eingang des invertierenden Nicht-Und-Gliedes (U) und damit über den Ladezustand des ersten Kondensators (C1) ein-und ausschaltbar ist. Am zweiten Ausgang (A2) ist das gegenüber dem Signal am ersten Ausgang (A1) invertierte Ausgangssignal abgreifbar.

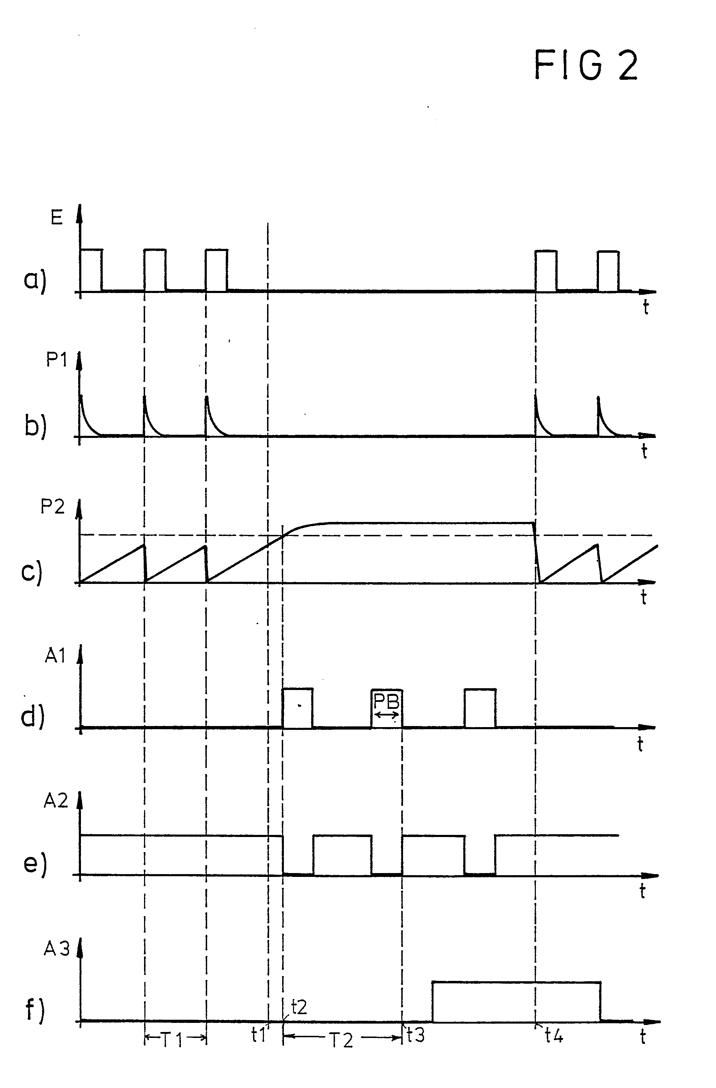

Die Funktion der erfindungsgemäßen Vorrichtung der Figur 1 wird nun anhand der Spannungszeitdiagramme einiger Meßpunkte der erfindungsgemäßen Vorrichtung der Figur 2 näher erläutert:

Bei ordnungsgemäßer Funktion des Mikrorechners (MC) liefert der Mikrorechner (MC) über dem Eingang (E) rechteckförmige Impulse mit vorgegebener gleichförmiger Frequenz an die Ladeschaltung (L), wie in Figur 2a dargestellt. Die rechteckförmigen Impulse des Mikrorechners (MC) werden, wie in der Figur 2b dargestellt, durch den dritten Kondensator (C3) zu Spannungsspitzen umgewandelt, die am ersten Meßpunkt (P1) meßbar sind und dem ersten Inverter (I1) zugeführt werden. In den Pausen zwischen zwei Spannungsspitzen am ersten Meßpunkt (P1) weist der Eingang des ersten Inverters (I) Minus-oder Masse-Potential auf, so daß der Ausgang des ersten Inverters (I1) positives Potential aufweist, das den ersten Kondensator (C1) über den ersten Widerstand (R1) auflädt, wie am zweiten Meßpunkt (P2) und in der Figur 2c dargestellt meßbar ist. Tritt eine Spannungsspitze am Eingang des ersten Inverters (I1) auf, so ändert der erste Inverter (I1) seinen Ausgangszustand auf Minus-oder Masse-Potential. Daraufhin wird der erste Kondensator (C1) auch über den ersten hochohmigen Widerstand (R1), vor allem aber über den vierten niederohmigen Widerstand (R4) und die zweite Diode (D2) sehr schnell entladen.

Solange der Mikrorechner (MC) die in Figur 2a dargestellten Impulse periodisch liefert, weist der erste Ausgang (A1), wie in Figur 2d dargestellt, konstant Minus-oder MassePotential auf. In diesem Fall weist der zweite Ausgang (A2), wie in Figur 2e dargestellt, konstant positives oder Versorgungsspannungs-Potential auf. Der dritte Ausgang (A3) weist, wie in Figur 2f dargestellt, konstant Minus-oder Masse-Potential in diesem Fall auf.

Um diesen Zustand aufrechtzuerhalten, darf die Periodendauer der Ausgangsimpulse des Mikrorechners (MC) oder auch der Entladeimpulse eine vorgegebene erste Periode (T1) nicht überschreiten. Diese erste Periode (T1) ist vorgegeben durch die Kapazität des ersten Kondensators (C1), die Größe des ersten Widerstandes (R1) und die Schwellenspannung am ersten Eingang des invertierenden Nicht-Und-Gliedes (U).

Bleiben die Entladeimpulse am Eingang (E) aus, so wird davon ausgegangen, daß der Mikrorechner (MC) nicht mehr einwandfrei funktioniert. Dann tritt innerhalb der vorgegebenen ersten Periode (T1) kein Impuls des Mikrorechners (MC) auf, und der erste Kondensator (C1) wird über den durch das Nicht-Und-Gatter (U) vorgegebenen Schwellwert hinaus aufgeladen, wie in Figur 2c dargestellt. Dies führt dazu, daß das invertierende Nicht-Und-Glied (U) seinen Ausgangszustand wechselt, und der freilaufende Schwingkreis (S) in bekannter Art und Weise beginnt zu schwingen, wie dies in Figur 2d dargestellt ist. Dort wird davon ausgegangen, daß der Entladeimpuls des Mikrorechners (MC) zum Zeitpunkt (t1) ausbleibt und daß zu einem Zeitpunkt (t2) die Spannung am ersten Kondensator (C1) den durch das Nicht-Und-Glied (U) vorgegebenen Schwellwert überschreitet und der Schwingkreis anfängt zu schwingen.

Am ersten Ausgang (A1) treten dann die in der Figur 2d dargestellten Rücksetzsignale oder Rücksetzimpulse auf, die als Resetimpulse einem Eingang des Mikrorechners (MC) zugeführt werden, um den Mikrorechner (MC) von einem definierten Betriebszustand aus wieder zu starten. Da es sich um einen freilaufenden Schwingkreis (S) handelt, werden diese Resetimpulse mit einer durch den Wert des zweiten Widerstandes (R2) und die Größe des zweiten Kondensators (C2) vorgegebenen zweiten Periode (T2) wiederholt. Die Breite der Resetimpulse (PB) ist durch Wahl der Widerstände (R2, R3) und der ersten Diode (D1) frei wählbar. Am zweiten Ausgang (A2) liegt, wie in der Figur 2e dargestellt, das gegenüber dem Signal am ersten Ausgang (A1) invertierte Ausgangssignal an, falls ein Rechner verwendet wird, der ein entsprechendes invertiertes Ausgangssignal zum Auslösen der Neustartfunktion benötigt.

Abhängig von der Größe des fünften Widerstandes (R5) und des vierten Kondensators (C4) wechselt auch der dritte Ausgang (A3) zu einer vorgegebenen dritten Zeit (T3) nach der zweiten Zeit (T2) seinen Ausgangszustand, wie dies in der Figur 2f dargestellt ist. Das Ausgangssignals des dritten Ausgangs (A3) ist zur Steuerung weiterer Teile der elektronischen Schaltung oder auch zur Steuerung eines Warnsignals verwendbar.

Es sei angenommen, daß der Mikrorechner (MC) zu einem vierten Zeitpunkt (T4) seinen Reset oder seine Wiederaufnahmeroutine beendet hat, so daß er zum vierten Zeitpunkt (T4) wieder rechteckförmige Ausgangssignale an den Eingang (E) liefert. Dann laufen die zu Beginn der Funktionsbeschreibung dargestellten Vorgänge erneut ab, und sämtliche Ausgänge (A1 - A3) nehmen ggf. nach einer Verzögerungszeit die dort beschriebenen Ausgangszustände wieder ein.

Die erfindungsgemäße Vorrichtung nach dem Ausführungsbeispiel der Figur 1 hat insbesondere den Vorteil, daß ein erstes R-C-Glied (R1 C1) zur Bestimmung der ersten Periode (T1) vorgesehen ist und daß ein zweites R-C-Glied (R2 + R3 C2) zur Bestimmung der zweiten Periode (T2) vorgesehen ist. Dadurch sind diese Perioden bzw. die Zeitdauern völlig unabhängig voneinander einstellbar, und die erfindungsgemäße Vorrichtung ist an nahezu jede elektronische Schaltung anpaßbar. Durch geeignete Wahl des dritten Widerstandes (R3) und des zweiten Widerstandes (R2) und der ersten Diode (D1) kann die Breite der am ersten Ausgang (A1) anstehenden Impulse zusätzlich nahezu beliebig eingestellt werden. Die Breite der vom Mikrorechner (MC) erzeugten Entladeimpulse spielt kaum eine Rolle.. Damit sind alle für die Funktion der erfindungsgemäßen Vorrichtung erforderlichen Zeitdauern unabhängig voneinander nahezu beliebig einstellbar und dadurch, daß insgesamt drei Ausgangsklemmen (A1 - A3) vorgesehen sind, ist die erfindungsgemäße Vorrichtung zur Überwachung nahezu aller möglichen elektronischen Schaltungen einfach und kostengünstig brauchbar.

Der Stromverbrauch der erfindungsgemäßen Vorrichtung ist auch verglichen mit dem Vorbekannten gering, weil zum Aufbau der erfindungsgemäßen Vorrichtung wenig Schaltungsteile erforderlich sind. Der Strombedarf kann weiter dadurch verringert werden, daß als erster Invertierer (I1), zweiter Invertierer (I2), erster Treiber (T1), zweiter Treiber (T2) und invertierendes Nicht-Und-Glied (U) C-Mos-Schaltkreise verwendet werden.

## Ansprüche

1. Vorrichtung zur Überwachung elektronischer Geräte, insbesondere von Mikrorechnern, mit einem Eingang, der mit einem Ausgang des elektronischen Geräts verbunden ist, mit einer Ladeschaltung, die ein R-C-Glied aufweist, das durch Signale des elektronischen Geräts entladbar ist, mit einem Schwingkreis, der abhängig vom Ladezustand des Kondensators schaltbar ist und der ein periodisches Rücksetzsignal erzeugt, und mit einem Ausgang, der mit einem Eingang des elektronischen Geräts verbunden ist und der das elektronische Gerät mit den Rücksetzsignalen des Schwingkreises versorgt, dadurch gekennzeichnet, daß die Ladeschaltung (L) getrennt von dem Schwingkreis (S) ausgebildet ist und daß der Schwingkreis (S) ein zweites R-C-Glied (R2-C2) zur Taktzeitfestlegung aufweist.

2. Vorrichtung nach Anspruch 1, dadurch gekennzeichnet, daß der Schwingkreis (S) ein drittes R-C-Glied (R3-C2) zur Einstellung des Tastverhältnisses aufweist.

3. Vorrichtung nach Anspruch 2, dadurch gekennzeichnet, daß das zweite R-C-Glied (R2-C2) und das dritte R-C-Glied (R3-C2) denselben Kondensator (C2) aufweisen und daß zwischen dem Kondensator (C2) und dem dritten Widerstand (R3) des dritten R-C-Gliedes (R3-C2) eine Diode (D2) angeordnet ist.

4. Vorrichtung nach Anspruch 1, dadurch gekennzeichnet, daß der Schwingkreis (S) einen zweiten Ausgang (A2) aufweist, an dem ein gegenüber dem Signal des ersten Ausgangs (A1) invertiertes Signal abgreifbar ist.

5. Vorrichtung nach Anspruch 1, dadurch gekennzeichnet, daß die Ladeschaltung (L) ein viertes R-C-Glied (R4-C1) zur Entladung des Kondensators (C1) aufweist.

6. Vorrichtung nach Anspruch 5, dadurch gekennzeichnet, daß das vierte R-C-Glied (R4-C1) und das erste R-C-Glied (R1-C1) denselben Kondensator (C1) aufweisen und daß zwischen dem Kondensator (C1) und dem vierten Widerstand (R4) des vierten R-C-Gliedes (R4 C1) eine zweite Diode (D2) angeordnet ist.

7. Vorrichtung nach Anspruch 6, dadurch gekennzeichnet, daß die Ladeschaltung (L) ein invertierendes Logikelement, insbesondere einen Inverter (I1) aufweist, dessen Ausgang parallel mit dem ersten R-C-Glied (R1 C1) und dem vierten R-C-Glied (R4 C1) verbunden ist und daß die Anode der zweiten Diode (D2) des vierten R-C-Glieds (R4 C1) mit dem Kondensator (C1) verbunden ist.

8. Vorrichtung nach Anspruch 1, dadurch gekennzeichnet, daß ein dritter Ausgang (A3) vorgesehen ist, dessen Ausgangssignal abhängig vom Ladezustand des ersten Kondensators (C1) änderbar ist.

9. Vorrichtung nach Anspruch 8, dadurch gekennzeichnet, daß mit dem Kondensator (C1) ein fünftes R-C-Glied (R5-C4) verbunden ist.

FIG 1

# FIG 2